# EUROPÄISCHE PATENTSCHRIFT

(11) **EP 3 600 752 B1**
(45) Veröffentlichungstag und Bekanntmachung des Hinweises auf die Patenterteilung: **10.07.2024**
(21) Anmeldenummer: 18714984.4
(22) Anmeldetag: 15.03.2018
(51) Int. Cl.: B23K 20/10, B23K 20/26, B06B 3/00, H01R 43/02, H01L 23/00, B23K 101/40, H01R 107/00

(54) **VERFAHREN ZUR HERSTELLUNG EINER SCHWEISSBAUGRUPPE**
METHOD FOR PRODUCING A WELDED ASSEMBLY
PROCÉDÉ DE FABRICATION D'UN ASSEMBLAGE SOUDÉ

(30) Priorität: 21.03.2017 DE 102017204657
(43) Veröffentlichungstag der Anmeldung: 05.02.2020
(73) Patentinhaber: Schunk Sonosystems GmbH, 35435 Wettenberg (DE)
(72) Erfinder: MUELA, Valentin, 35606 Solms (DE)
(74) Vertreter: advotec.
(86) Internationale Anmeldenummer: PCT/EP2018/056587
(87) Internationale Veröffentlichungsnummer: WO 2018/172189

(56) Entgegenhaltungen:
- US-A1- 2001 016 786
- US-A1- 2001 042 770
- US-A1- 2010 006 231

## Beschreibung

Die vorliegende Erfindung betrifft ein Verfahren zur Herstellung einer Schweißbaugruppe mit einer Mehrzahl von Schweißverbindungen zwischen ersten Kontaktpartnern eines Kontaktsubstrats und zweiten Kontaktpartnern einer vorzugsweise als Halbleiterbaugruppe ausgeführten Bestückungseinheit, bei dem zur Relativpositionierung der ersten und zweiten Kontaktpartner in einer Schweißposition die Kontaktpartner in einer Überdeckungslage angeordnet werden und zur Positionierung der Sonotrode in den einzelnen Schweißpositionen die Sonotrode mittels einer Positioniereinrichtung in eine Überdeckungslage mit dem zweiten Kontaktpartner gebracht, zur Herstellung einer Schweißverbindung in eine Schweißkontaktposition auf den zweiten Kontaktpartner abgesenkt und mit Ultraschallschwingungen beaufschlagt wird, wobei die Positionierung der Sonotrode gegenüber dem zweiten Kontaktpartner mittels einer mit einer Bildverarbeitungseinrichtung versehenen Kameraeinrichtung erfolgt, derart, dass die Positionierung der Sonotrode gegenüber dem zweiten Kontaktpartner basierend auf einer Ermittlung einer Lageabweichung eines durch den Schweißvorgang auf einem Referenzabdruckträger erzeugten Sonotrodenabdrucks einer Sonotrodenarbeitsfläche der Sonotrode erfolgt.

Insbesondere zur Herstellung von Leistungsmodulen, bei denen eine Mehrzahl von Terminals einer Halbleiterbaugruppe mit einer entsprechenden Anzahl von Anschlussflächen eines Schaltungssubstrats kontaktiert ist, wird auch in der Ultraschallschweißtechnik eine weitestgehend automatisierte Herstellung der Verbindungsstellen durchgeführt, wobei die Terminals mit den Anschlussflächen mittels einer Sonotrode verschweißt werden, die sukzessive zu den regelmäßig auf einer Achse angeordneten Schweißpositionen verfahren und aus der jeweiligen Schweißposition in Schweißkontaktposition gegen den auf der Anschlussfläche angeordneten Terminal verfahren wird.

Hieraus ergibt sich die Notwendigkeit, das zur Durchführung des Schweißvorgangs der Kontakt der Sonotrode mit dem als Terminal ausgebildeten zweiten Kontaktpartner zuverlässig und somit auch in korrekter Relativposition erfolgt. Da die Abstände der Anschlussflächen mit den Abständen der Terminals regelmäßig übereinstimmen und die Positioniereinrichtung einen dem Abstand entsprechenden getakteten Vorschub ausführt, ergibt sich eine korrekte Relativpositionierung der Sonotrode gegenüber den als Terminals ausgebildeten zweiten Kontaktpartnern ohne weiteres, so lange die Terminals keine, etwa durch äußere Gewalteinwirkung verursachte fehlerhafte Ausrichtung aufweisen, also beispielsweise verbogen sind.

Bei den bislang angewendeten Verfahren zur automatisierten UltraschallVerschweißung der Terminals der Halbleiterbaugruppen mit den Substratanschlussflächen wird zur Positionierung der Sonotrode gegenüber den Terminals eine mit einer Bildverarbeitungseinrichtung versehene Kameraeinrichtung eingesetzt, sodass bei einer festgestellten Lageabweichung der Sonotrode gegenüber dem zweiten Kontaktpartner die Größe der Lageabweichung ermittelt und gegebenenfalls eine entsprechende Korrektur bei der Positionierung der Sonotrode gegenüber dem Terminal erfolgt.

Die Positionierung der Sonotrode gegenüber der Positioniereinrichtung, die beispielsweise nach einem Sonotrodenwechsel erforderlich wird, erfolgt über ein Achsmesssystem, bei dem die Position einer Sonotrodenarbeitsfläche, die den Bereich der Schweißverbindung zwischen den Kontaktpartnern definiert, indirekt über den Achsabstand von an der Sonotrode definierten Bezugskanten zu entsprechenden Bezugskanten der Positioniereinrichtung festgelegt wird. Etwaige Lagefehler der Sonotrodenarbeitsfläche der Sonotrode werden durch eine Änderung der Relativanordnung der Sonotrode gegenüber der Positioniereinrichtung berücksichtig, also etwa durch Änderung der Einspannung der Sonotrode in einer Sonotrodenaufnahme. Hiermit ist insbesondere nach einem Sonotrodenwechsel ein entsprechender Aufwand verbunden.

Die US 2001/016786 A1 offenbart eine Vorrichtung zur Durchführung eines Verfahrens zur Herstellung einer Schweißbaugruppe. Eine Kamera der Vorrichtung ist hier mit einem Versatz zu einem Sonotrodenkopf der Vorrichtung angeordnet, wobei sich eine optische Achse der Kamera in einer zu einer Zustellachse des Sonotrodenkopfes parallelen Ausrichtung befindet.

Der vorliegenden Erfindung liegt die Aufgabe zugrunde, ein Verfahren zu ermöglichen, derart, dass eine Korrektur von Sonotrodenfehlern mit verringertem Aufwand erfolgen kann.

Zur Lösung dieser Aufgabe weist das erfindungsgemäße Verfahren die Merkmale des Anspruchs 1 auf.

Erfindungsgemäß erfolgt die Positionierung der Sonotrode gegenüber dem zweiten Kontaktpartner mittels einer mit einer Bildverarbeitungseinrichtung versehenen Kameraeinrichtung, derart, dass die Positionierung der Sonotrode gegenüber dem zweiten Kontaktpartner basierend auf einer Ermittlung einer Lageabweichung eines durch den Schweißvorgang auf einem Referenzabdruckträger erzeugten Sonotrodenabdrucks einer Sonotrodenarbeitsfläche der Sonotrode erfolgt.

Eine fehlerhafte Sonotrode mit einer Lageabweichung der Sonotrodenarbeitsfläche, also beispielsweise einer nicht zentral, sondern mit seitlichem Versatz in einer Sonotrodenoberfläche angeordneten Sonotrodenarbeitsfläche, kann somit bei der Positionierung der Sonotrode in Schweißposition berücksichtigt werden, ohne dass es notwendig wäre, die Sonotrode auszutauschen oder die Einspannung der Sonotrode in der Sonotrodenaufnahme zu ändern. Vielmehr kann eine Kompensation des Sonotrodenfehlers durch die Positioniereinrichtung erfolgen, wobei der Betrag der notwendigen Kompensation von dem Betrag der Lageabweichung des Sonotrodenabdrucks von einer definierten Soll-Position des Sonotrodenabdrucks auf dem Referenzabdruckträger abhängig ist.

Bei dem Referenzabdruckträger kann es sich um einen in der Ausgestaltung und insbesondere im Material einem zweiten Kontaktpartner entsprechenden Materialstreifen handeln. Natürlich kann auch ein zweiter Kontaktpartner als Referenzabdruckträger dienen.

Vorzugsweise erfolgt die Positionierung der Sonotrode gegenüber dem zweiten Kontaktpartner sowohl basierend auf einer Lageabweichung der Sonotrode gegenüber dem zweiten Kontaktpartner als auch basierend auf der Lageabweichung des durch den Schweißvorgang auf dem Referenzabdruckträger erzeugten Sonotrodenabdrucks der Sonotrodenarbeitsfläche der Sonotrode, wobei beide Lageabweichungen mittels der mit einer Bildverarbeitungseinrichtung versehenen Kameraeinrichtung ermittelt werden. Somit können beide Lageabweichungen mit ein und derselben Einrichtung erfasst werden.

Wenn eine aus den Lageabweichungen zusammengesetzte Gesamtlageabweichung einem dem Abstand zwischen ersten Kontaktpartnern des Kontaktsubtrats entsprechenden Vorschubweg der Positioniereinrichtung überlagert wird, kann die Kompensation der Lageabweichungen und der Vorschub zur Überführung der Sonotrode von einer Schweißposition in die nachfolgende Schweißposition als eine einzige Vorschubbewegung ausgeführt werden.

Vorzugsweise erfolgt die Ermittlung der Lageabweichung des Sonotrodenabdrucks nach einer Änderung der Relativposition der Sonotrode gegenüber der Positioniereinrichtung, also etwa nach einem Sonotrodenwechsel, so dass bei der nachfolgenden Positionierung der Sonotrode in den unterschiedlichen Schweißpositionen die einmal ermittelte Lageabweichung als unveränderlicher Wert beim Anfahren der nachfolgenden Schweißpositionen berücksichtigt wird. Bei Bedarf ist es natürlich auch möglich, die Lageabweichung des Sonotrodenabdrucks nach jedem Schweißvorgang zu ermitteln und jeweils beim Anfahren der nachfolgenden Schweißposition zu berücksichtigen.

Bei der nicht erfindungsgemäßen Vorrichtung zur Durchführung des erfindungsgemäßen Verfahrens ist die mit einer Bildverarbeitungseinrichtung versehene Kameraeinrichtung an der Positioniereinrichtung angeordnet, derart, dass in jeder der nacheinander von der Positioniereinrichtung angefahrenen Schweißpositionen sich die Kontaktpartner in einer durch die Kameraeinrichtung definierten Bildebene befinden.

Vorzugsweise ist bei der nicht erfindungsgemäßen Vorrichtung die Relativposition der Kameraeinrichtung gegenüber einer an der Positioniereinrichtung angeordneten Sonotrodenaufnahme fixiert.

Nachfolgend wird eine bevorzugte Ausführungsform der Erfindung anhand der Zeichnungen näher erläutert.

Es zeigen:
- **Fig. 1**: ein auf einer Kontaktsubstrataufnahme angeordnetes Kontaktsubstrat mit zwei gegenüber dem Kontaktsubstrat mittels einer Positioniereinrichtung verfahrbaren Sonotroden;
- **Fig. 2**: eine in einer Sonotrodenaufnahme angeordnete Sonotrode in Seitenansicht;
- **Fig. 3**: die in **Fig. 2** dargestellte Sonotrode in Schweißausgangsposition;
- **Fig. 4**: die in **Fig. 2** dargestellte Sonotrode in Schweißkontaktposition;
- **Fig. 5**: einen Sonotrodenabdruck bei einer fehlerfreien Schweißverbindung;
- **Fig. 6**: einen Sonotrodenabdruck bei einem fehlerhaft positionierten Kontaktpartner;
- **Fig. 7**: einen Sonotrodenabdruck nach erfolgter Anpassung der Sonotrodenposition an den fehlerhaft positionierten Kontaktpartner;
- **Fig. 8**: einen Sonotrodenabdruck einer fehlerhaften Sonotrode;
- **Fig.9**: einen Sonotrodenabdruck einer fehlerhaften Sonotrode.

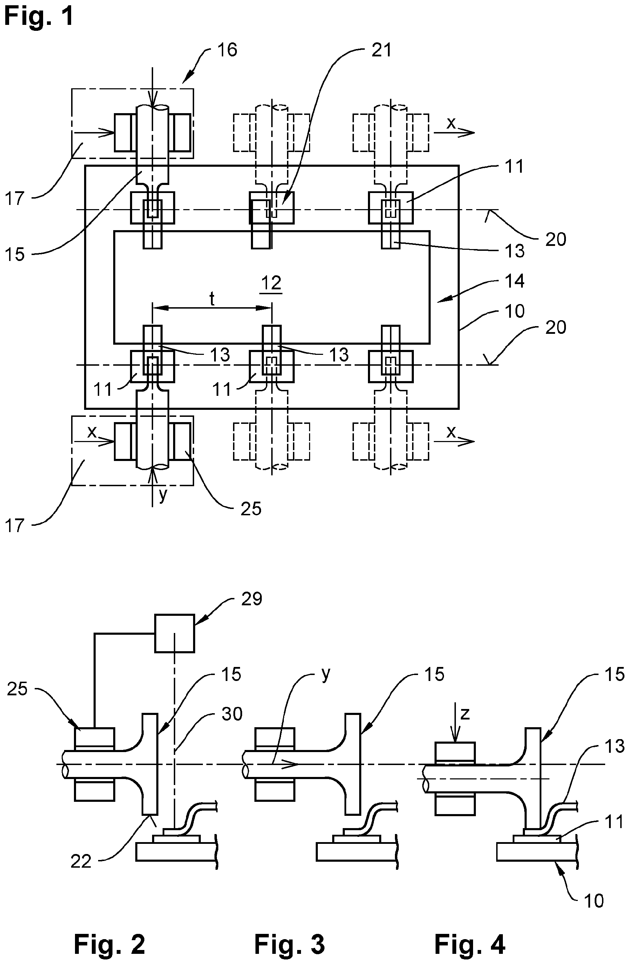

**Fig. 1** zeigt in einer schematischen Darstellung und in Draufsicht ein Kontaktsubstrat 10 mit einer Mehrzahl von in Kontaktreihen 20 angeordneten und als Kontaktflächen ausgebildeten ersten Kontaktpartnern 11 und eine Halbleiterbaugruppe 12, die mit einer Mehrzahl von zweite Kontaktpartner 13 bildenden Terminals 13 versehen ist. Zur Herstellung einer aus dem Kontaktsubstrat 10 und der Halbleiterbaugruppe 12 hergestellten Schweißbaugruppe 14 wird ausgehend von der in Fig. 1 dargestellten Relativpositionierung der zweiten Kontaktpartner 13 der Halbleiterbaugruppe 12 auf den ersten Kontaktpartnern 11 des Kontaktsubstrats 10 jeweils eine auf einer Längsseite des Kontaktsubstrats 10 angeordnete, mit einer Sonotrode 15 versehene Ultraschallschweißeinheit 16 mittels einer Positioniereinrichtung 17 sukzessive in eine in den **Fig. 1 und 3** dargestellte Schweißausgangsposition oberhalb der zweiten Kontaktpartner 13 verfahren und anschließend in die in **Fig. 4** dargestellte Schweißkontaktposition abgesenkt. Hierzu ermöglicht die Positioniereinrichtung 17 ein Verfahren der Sonotroden 15 längs der drei Raumachsen in x-, y- und z-Richtung.

**Fig. 1** zeigt jeweils eine auf jeder Längsseite des Kontaktsubstrats 10 angeordnete Sonotrode 15, die nach Ausführung einer ersten Schweißverbindung in die nachfolgenden, gestrichelt dargestellten weiteren Schweißpositionen verfahren wird.

Aus der Darstellung in **Fig. 1** wird deutlich, dass die Schweißausgangsposition der Sonotrode 15 durch eine entsprechende Positionierung einer Sonotrodenarbeitsfläche 22 (**Fig**. **2** bis **4**) in der x/y-Ebene definiert ist. Ausgehend von der Schweißausgangsposition wird, wie aus einer Zusammenschau der **Fig. 3** und **4** deutlich wird, die Sonotrode 15 mit der Sonotrodenarbeitsfläche 22 mit definierter Anpresskraft auf den oberen, zweiten Kontaktpartner 13 in die Schweißkontaktposition abgesenkt, und es erfolgt zur Durchführung des Schweißvorgangs die Ultraschallbeaufschlagung der Sonotrode 15.

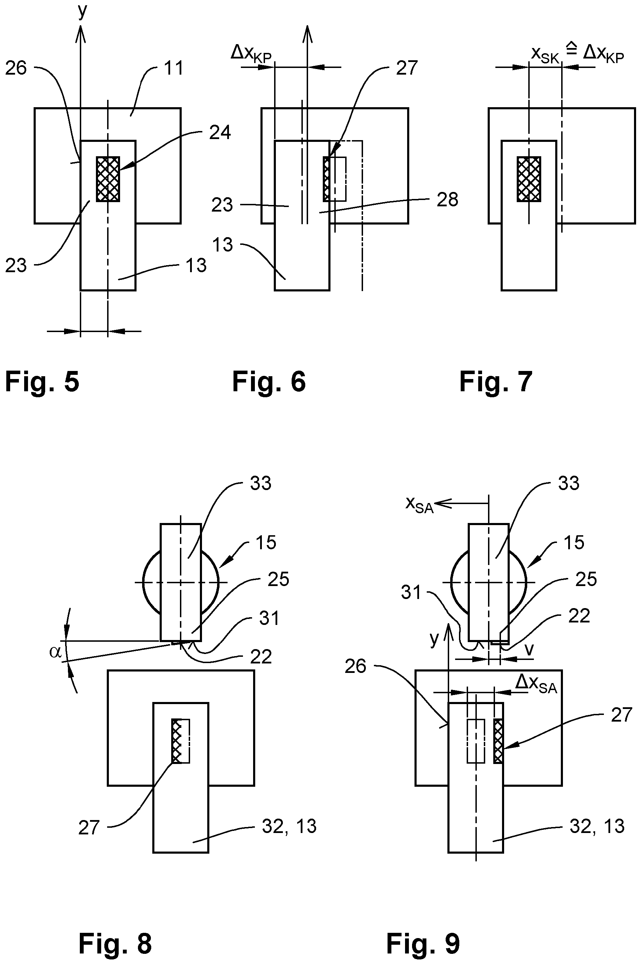

Nach Durchführung des Schweißvorgangs ist, wie insbesondere die **Fig. 5** zeigt, infolge der Ultraschallbeaufschlagung des zweiten Kontaktpartners 13 mit der Sonotrodenarbeitsfläche 22 auf dem zweiten Kontaktpartner 13 ein Sonotrodenabdruck 24 ausgebildet, der dadurch entsteht, dass sich eine profilierte Oberfläche der Sonotrodenarbeitsfläche 22 in eine Kontaktoberfläche 23 des zweiten Kontaktpartners 13 einprägt, sodass eine Negativabbildung der profilierten Sonotrodenarbeitsfläche auf der Kontaktoberfläche 23 erkennbar ist.

In **Fig. 5** ist eine fehlerfreie Schweißverbindung dargestellt, bei der sowohl zwischen dem ersten Kontaktpartner 11 und dem zweiten Kontaktpartner 13 eine vollständige Überdeckung ausgebildet ist, als auch auf der Kontaktoberfläche 23 des zweiten Kontaktpartners 13 der vollständigen Sonotrodenabdruck 24 abgebildet ist.

Im Unterschied zu der **Fig. 5** zeigt die **Fig. 6** eine fehlerhafte Schweißverbindung mit einem nur unvollständigen Sonotrodenabdruck 27 auf der Kontaktoberfläche 23 des zweiten Kontaktpartners 13, die darauf zurückzuführen ist, dass sich der zweite Kontaktpartner 13 nicht in seiner in **Fig.5** dargestellten Sollposition gegenüber dem ersten Kontaktpartner 11 befindet. Die Ursache hierfür kann beispielsweise sein, dass der zweite Kontaktpartner 13 verbogen ist.

Bei der sukzessiven Überführung der Sonotroden 15 längs den Kontaktreihen 20 in die jeweiligen Schweißausgangspositionen erfolgt entsprechend den Teilungsabständen t der ersten Kontaktpartner 11 ein getaktetes Vorbewegen der mit den Sonotroden 15 bestückten Sonotrodenaufnahmen 25. Die Teilungsabstände t der ebenfalls in Reihenanordnungen 20 angeordneten zweiten Kontaktpartner 13 der Halbleiterbaugruppe 12 sind regelmäßig übereinstimmend mit den Teilungsabständen der ersten Kontaktpartner 11, sodass sich in der Regel die für die Durchführung eines fehlerfreien Ultraschallschweißvorgangs notwendige Überdeckung der zweiten Kontaktpartner 13 mit den ersten Kontaktpartnern 11 einstellt.

In der Praxis hat sich jedoch herausgestellt, dass es durchaus zu vereinzelten Fehlstellungen der zweiten Kontaktpartner 13 kommen kann, so wie in **Fig. 1** am Beispiel der mittleren Kontaktpaarung 21 in der oberen Kontaktreihe 20 gezeigt, wobei der zweite Kontaktpartner 13 gegenüber der in **Fig. 5** dargestellten Sollposition einer Bezugskante 26 des zweiten Kontaktpartners 13 einen in **Fig. 6** dargestellten Versatz Δx_{KP} aufweist, der im vorliegenden nur in x-Richtung gegeben ist und dazu führt, dass eine um den Teilungsabstand t der ersten Kontaktpartner 11 längs der Kontaktreihe 20 in x-Richtung vorbewegte Sonotrode 15 sich nunmehr in einer Schweißausgangsposition befindet, in der sich die Sonotrode 15 nicht in einer Relativposition gegenüber dem zweiten Kontaktpartner 13 befindet, die einen Schweißkontakt zur Erzeugung des in **Fig. 5** dargestellten Sonotrodenabdrucks 24 ermöglicht. Vielmehr würde ein Schweißkontakt ausgehend von der in **Fig. 1** dargestellten Relativposition der Sonotrodenarbeitsfläche 22 gegenüber dem zweiten Kontaktpartner 13 zur Ausbildung eines beispielhaft in **Fig. 6** dargestellten Sonotrodenabdrucks 27 führen, derart, dass entsprechend dem Sonotrodenabdruck 27 eine Schweißverbindung zwischen dem ersten Kontaktpartner 11 und dem zweiten Kontaktpartner 13 lediglich in einem schmalen Randbereich 28 des zweiten Kontaktpartners 13 ausgebildet wird.

Wie bereits Bezug nehmend auf **Fig. 1** erläutert, sind die Sonotroden 15 in Sonotrodenaufnahmen 25 aufgenommen, die mittels der Sonotrodenpositioniereinrichtung 17 in x-Achsenrichtung, also längs den Kontaktreihen 20 des Kontaktsubstrats 10 verfahrbar sind. Die Sonotrodenpositioniereinrichtung 17 ermöglicht vorzugsweise auch eine Verfahrbarkeit der Sonotroden 15 gegenüber den Sonotrodenaufnahmen 25, sodass die Sonotrode 15 bzw. die Sonotrodenarbeitsfläche 22 aus einer in **Fig. 2** dargestellten Rückzugsposition in die **Fig. 3** dargestellte Schweißausgansposition oberhalb der Kontaktpaarung 21 in y-Richtung verfahren und anschließend ebenfalls vermittels der Sonotrodenpositioniereinrichtung 17 durch Ausführung einer Bewegung in z-Achsenrichtung in eine Schweißkontaktposition zur Ausführung der Schweißverbindung verfahren werden kann.

An der Sonotrodenaufnahme 25 befindet sich bevorzugt oberhalb der Sonotrode 15 eine Kameraeinrichtung 29, die mit ihrer optischen Achse 30 auf die Kontaktpaarung 21 ausgerichtet ist, derart, dass ausgehend von der bekannten Soll-Position der Bezugskante 26 des zweiten Kontaktpartners 13 über eine der Kameraeinrichtung 29 zugeordnete Bildverarbeitungseinrichtung die Lageabweichung Δx_{KP}, Δy_{KP} bestimmt werden kann und umgewandelt in ein entsprechendes Stellsignal an die Positioniereinrichtung 17 übermittelt und von dieser als Stellgröße auf die Sonotrodenaufnahme 25 zur Ausführung eines Stellweges x_{SK}, y_{SK} der Sonotrode 15 übertragen wird. Zur vereinfachten Darstellung zeigen die **Fig. 6** und **7** lediglich Lageabweichungen in x-Richtung. Somit befindet sich dann die Sonotrode 15 in einer korrigierten Schweißausgangsposition, die einen Schweißkontakt der Sonotrodenarbeitsfläche 22 mit dem zweiten Kontaktpartner 13 ermöglicht, der den in **Fig. 7** dargestellten Sonotrodenabdruck 24 erzeugt.

**Fig. 5** zeigt eine ideale Schweißkontaktausbildung mit einem im Wesentlichen mittigen Sonotrodenabdruck 24 auf dem zweiten Kontaktpartner 13. Eine derartige Relativpositionierung des Sonotrodenabdrucks 24 setzt eine geeignete Relativpositionierung der Sonotrode 15 und insbesondere der den Sonotrodenabdruck 24 erzeugenden Sonotrodenarbeitsfläche 22 gegenüber den durch die Kontaktflächen des Kontaktsubstrats 10 gebildeten ersten Kontaktpartnern 11 voraus.

Insbesondere nach einem Sonotrodenwechsel ist es daher bislang erforderlich, Justierungen an der Positionierung der Sonotrode 15 in der Sonotrodenaufnahme 25 vorzunehmen, um etwaige Toleranzen in der Anordnung der Sonotrodenarbeitsfläche 22 in einer an einem Sonotrodenkopf 33 ausgebildeten Kontaktoberfläche 31 auszugleichen. Insbesondere kann die Sonotrodenarbeitsfläche 22 Lagetoleranzen aufweisen, derart, dass beispielsweise die Sonotrodenarbeitsfläche 22 nicht parallel zur Kontaktoberfläche 31 ausgebildet ist, sondern um einen Fehlerwinkel α gegenüber der Kontaktoberfläche 31 geneigt ist. Diese Lageabweichung führt dazu, dass, wie beispielsweise in **Fig. 8** dargestellt, selbst bei korrekter Positionierung der Sonotrode 15 gegenüber dem ersten Kontaktpartner 11 und korrekter Positionierung eines Referenzabdruckträgers 32 bzw. eines zweiten Kontaktpartners 13 gegenüber dem ersten Kontaktpartner 11 nach einem Schweißkontakt zwischen der Sonotrodenarbeitsfläche 22 und dem Referenzabdruckträger 32 bzw. dem zweiten Kontaktpartner 13 der Sonotrodenabdruck 27 und damit der Schweißkontakt nur unvollständig ausgebildet ist.

Ein ebenfalls nur unvollständiger Schweißkontakt ist die Folge, wenn, wie in **Fig. 9** dargestellt, die Sonotrodenarbeitsfläche 22 nicht mittig in der Kontaktoberfläche 31 des Sonotrodenkopfs 33 sondern mit einem Versatz v angeordnet ist, so dass auch hier nur ein unvollständiger Sonotrodenabdruck 27 die Folge ist.

Im Falle des in **Fig.8** dargestellten unvollständigen Sonotrodenabdrucks 27, der bei korrekter Ausrichtung der Sonotrode 15 in der Sonotrodenaufnahme 25 auf eine Disparallelität zwischen der Sonotrodenarbeitsfläche 22 und der Kontaktoberfläche hindeutet, ist in der Regel ein Austausch der Sonotrode 15 vorzunehmen, da es sich um einen mittels der Positioniereinrichtung 17 nicht auszugleichenden Sonotrodenfehler handelt.

In dem Fall des in **Fig.9** dargestellten seitlichen Versatzes v, kann der Versatz v mittels der Sonotrodenpositioniereinrichtung 17 ausgeglichen werden. Hierzu kann zunächst mittels der bereits beschriebenen, mit der Bildverarbeitungseinrichtung 30 versehenen Kameraeinrichtung 29 die Lageabweichung Δx_{SA}, die im vorliegenden Fall nur in x-Richtung gegeben ist, ermittelt und zur Korrektur durch einen entsprechenden, von der Positioniereinrichtung 17 ausgeführten Stellweg x_{SA} auf die Sonotrode 15 übertragen werden.

Bei einer nachfolgenden Durchführung von Schweißvorgängen wird der Stellweg x_{SA}, der zum Ausgleich des Toleranzfehlers der Sonotrode 15 dient, durch die Positioniereinrichtung 17 beim Anfahren jeder Schweißausgangsposition zusätzlich zu dem für jeden zweiten Kontaktpartner 13 individuell ermittelten Stellweg x_{KP} ausgeführt.

## Patentansprüche

1. Verfahren zur Herstellung einer Schweißbaugruppe (14) mit einer Mehrzahl von Schweißverbindungen zwischen ersten Kontaktpartnern (11) eines Kontaktsubstrats (10) und zweiten Kontaktpartnern (13) einer vorzugsweise als Halbleiterbaugruppe (12) ausgeführten Bestückungseinheit, bei dem zur Relativpositionierung der ersten und zweiten Kontaktpartner (11, 13) in einer Schweißposition die Kontaktpartner (11, 13) in einer Überdeckungslage angeordnet werden und zur Positionierung einer Sonotrode (15) in einzelnen Schweißpositionen die Sonotrode (15) mittels einer Positioniereinrichtung (17) in eine Überdeckungslage mit dem zweiten Kontaktpartner (13) gebracht und zur Herstellung einer Schweißverbindung in Schweißkontaktposition auf den zweiten Kontaktpartner (13) abgesenkt und mit Ultraschallschwingungen beaufschlagt wird, wobei die Positionierung der Sonotrode (15) gegenüber dem zweiten Kontaktpartner (13) mittels einer mit einer Bildverarbeitungseinrichtung versehenen Kameraeinrichtung (29) erfolgt,
**dadurch gekennzeichnet,**
**dass** die Positionierung der Sonotrode (15) gegenüber dem zweiten Kontaktpartner (13) basierend auf einer Ermittlung einer Lageabweichung Δx_{SA}, Δy_{SA} eines durch den Schweißvorgang auf einem Referenzabdruckträger (32) erzeugten Sonotrodenabdrucks (27) einer Sonotrodenarbeitsfläche (22) der Sonotrode (15) erfolgt, wobei der Referenzabdruckträger eine definierte Soll Position des Sonotrodenabdrucks aufweist.

2. Verfahren nach Anspruch 1,
**dadurch gekennzeichnet,**
**dass** die Positionierung der Sonotrode (15) gegenüber dem zweiten Kontaktpartner (13) sowohl basierend auf einer Lageabweichung Δx_{KP}, Δy_{KP} der Sonotrode (15) gegenüber dem zweiten Kontaktpartner (13) als auch basierend auf der Lageabweichung Δx_{SA}, Δy_{SA} des durch den Schweißvorgang auf dem Referenzabdruckträger (32) erzeugten Sonotrodenabdrucks (27) der Sonotrodenarbeitsfläche (22) der Sonotrode (15) erfolgt, wobei beide Lageabweichungen Δx_{KP}, Δy_{KP}; Δx_{SA}, Δy_{SA} mittels der mit einer Bildverarbeitungseinrichtung versehenen Kameraeinrichtung (29) ermittelt werden.

3. Verfahren nach Anspruch 1 oder 2,
**dadurch gekennzeichnet,**
**dass** eine aus den Lageabweichungen Δx_{KP}, Δy_{KP}; Δx_{SA}, Δy_{SA} zusammengesetzte Gesamtlageabweichung einem dem Abstand t zwischen ersten Kontaktpartnern (11) des Kontaktsubtrats (10) entsprechenden Vorschubweg der Positioniereinrichtung (17) überlagert wird.

4. Verfahren nach einem der vorangehenden Ansprüche,
**dadurch gekennzeichnet,**
**dass** die Ermittlung der Lageabweichung des Δx_{SA}, Δy_{SA} Sonotrodenabdrucks (27) nach einer Änderung der Relativposition der Sonotrode (15) zur Positioniereinrichtung (17) erfolgt.

## Claims

1. A method for producing a welded assembly (14) comprising a plurality of welded connections between first contact partners (11) of a contact substrate (10) and second contact partners (13) of a placement unit, which is preferably a semiconductor assembly (12), in which the contact partners (11, 13) are arranged in an overlapping position to position the first and second contact partners (11, 13) relative to each other in a welding position and a sonotrode (15) is moved into a position overlapping with the second contact partner (13) by means of a positioning device (17) to position the sonotrode (15) in individual welding positions and is lowered onto the second contact partner (13) in a welding contact position and is subjected to ultrasonic vibrations to produce a welded connection, the sonotrode (15) being positioned relative to the second contact partner (13) by means of a camera device (29), which is provided with an image processing device,
**characterized in that**
the sonotrode (15) is positioned relative to the second contact partner (13) based on a determination of a position deviation Δx_{SA}, Δy_{SA} of a sonotrode imprint (27) of a sonotrode working surface (22) of the sonotrode (15) produced on a reference imprint carrier (32) by the welding process, the reference imprint carrier presenting a defined target position of the sonotrode imprint.

2. The method according to claim 1,
**characterized in that**
the sonotrode (15) is positioned relative to the second contact partner (13) both based on a position deviation Δx_{KP}, Δy_{KP} of the sonotrode (15) relative to the second contact partner (13) and based on the position deviation Δx_{SA}, Δy_{SA} of the sonotrode imprint (27) of the sonotrode working surface (22) of the sonotrode (15) produced on the reference imprint carrier (32) by the welding process, both position deviations Δx_{KP}, Δy_{KP}; Δx_{SA}, Δy_{SA} being determined using the camera device (29) provided with an image processing device.

3. The method according to claim 1 or 2,
**characterized in that**
a total position deviation which consists of the position deviations Δx_{KP}, Δy_{KP}; Δx_{SA}, Δy_{SA} is superimposed on a feed path of the positioning device (17) which corresponds to the distance t between first contact partners (11) of the contact substrate (10).

4. The method according to any one of the preceding claims,
**characterized in that**
the position deviation Δx_{SA}, Δy_{SA} of the sonotrode imprint (27) is determined after a change in the position of the sonotrode (15) relative to the positioning device (17).

## Revendications

1. Procédé de fabrication d'un assemblage soudé (14) comprenant une pluralité de joints soudés entre des premiers partenaires de contact (11) d'un substrat de contact (10) et des deuxièmes partenaires de contact (13) d'une unité de garnissage, qui est de préférence un assemblage semi-conducteur (12), dans lequel les partenaires de contact (11, 13) sont placés dans une position de chevauchement afin de positionner les premiers et les deuxièmes partenaires de contact (11, 13) l'un par rapport à l'autre dans une position de soudage et une sonotrode (15) est placée dans une position de chevauchement avec le deuxième partenaire de contact (13) au moyen d'un dispositif de positionnement (17) afin de positionner la sonotrode (15) dans des positions de soudage individuelles et le sonotrode (15) est abaissée sur le deuxième partenaire de contact (13) dans une position de contact de soudage et soumise à des vibrations ultrasoniques afin to produire un joint soudé, la sonotrode (15) étant positionnée par rapport au deuxième partenaire de contact (13) au moyen d'un dispositif de caméra (29) muni d'un dispositif de traitement d'images,
**caractérisé en ce que**
la sonotrode (15) est positionnée par rapport au deuxième partenaire de contact (13) sur la base d'une détermination d'une déviation de position Δx_{SA}, Δy_{SA} d'une empreinte de sonotrode (27) d'une surface de travail de sonotrode (22) de la sonotrode (15) produite sur un support d'empreinte de référence (32) par le soudage, le support d'empreinte de référence présentant une position cible définie de l'empreinte de sonotrode.

2. Procédé selon la revendication 1,
**caractérisé en ce que**
la sonotrode (15) est positionnée par rapport au deuxième partenaire de contact (13) sur la base d'une déviation de position Δx_{KP}, Δy_{KP} de la sonotrode (15) par rapport au deuxième partenaire de contact (13) ainsi que sur la base de la déviation de position Δx_{SA}, Δy_{SA} de l'empreinte de sonotrode (27) de la surface de travail de sonotrode (22) de la sonotrode (15) produite sur la support d'empreinte de référence (32) par le soudage, les deux déviations de position Δx_{KP}, Δy_{KP}; Δx_{SA}, Δy_{SA} étant déterminées en utilisant le dispositif de caméra (29) muni d'un dispositif de traitement d'images.

3. Procédé selon la revendication 1 ou 2,
**caractérisé en ce**
**qu'**une déviation de position totale se composant des déviations de position Δx_{KP}, Δy_{KP}; Δx_{SA}, Δy_{SA} est superposée sur une trajectoire d'avance du dispositif de positionnement (17), qui correspond à la distance t entre des premiers partenaires de contact (11) du substrat de contact (10).

4. Procédé selon l'une quelconque des revendications précédentes,
**caractérisé en ce que**
la déviation de position Δx_{SA}, Δy_{SA} de l'empreinte de sonotrode (27) est déterminée après un changement de la position de la sonotrode (15) par rapport au dispositif de positionnement (17).
